# FASCICULE DE BREVET EUROPEEN

(11) **EP 3 002 788 B1**
(45) Date de publication et mention de la délivrance du brevet: **07.06.2023**
(21) Numéro de dépôt: 15184711.8
(22) Date de dépôt: 10.09.2015
(51) Int. Cl.: H10B 10/00, H01L 27/12, H01L 21/84, H01L 29/786

(54) **DISPOSITIF A CELLULES MEMOIRES SRAM COMPORTANT DES MOYENS DE POLARISATION DES CAISSONS DES TRANSISTORS DES CELLULES MEMOIRES**
VORRICHTUNG MIT SRAM-SPEICHERZELLEN DIE MITTELN ZUR POLARISIERUNG DER WANNEN DER SPEICHERZELLTRANSISTOREN UMFASST
DEVICE WITH SRAM MEMORY CELLS COMPRISING MEANS FOR POLARISING THE WELLS OF THE MEMORY CELL TRANSISTORS

(30) Priorité: 10.09.2014 FR 1458488
(43) Date de publication de la demande: 06.04.2016
(73) Titulaire: Commissariat à l'Énergie Atomique et aux Énergies Alternatives, 75015 Paris (FR)
(72) Inventeur: THOMAS, Olivier, 38420 Revel (FR); GIRAUD, Bastien, 38340 Voreppe (FR); MAKOSIEJ, Adam, 38000 Grenoble (FR)
(74) Mandataire: Brevalex

(56) Documents cités:
- US-A1- 2007 076 467
- BEIGNE E ET AL: "Ultra-Wide Voltage Range designs in Fully-Depleted Silicon-On-Insulator FETs", DESIGN, AUTOMATION&TEST IN EUROPE CONFERENCE&EXHIBITION (DATE), 2013, IEEE, 18 mars 2013 (2013-03-18), pages 613-618, XP032395787, DOI: 10.7873/DATE.2013.135 ISBN: 978-1-4673-5071-6
- ASTHANA VIVEK ET AL: "Circuit optimization of 4T, 6T, 8T, 10T SRAM bitcells in 28nm UTBB FD-SOI technology using back-gate bias control", 2013 PROCEEDINGS OF THE ESSCIRC (ESSCIRC), IEEE, 16 septembre 2013 (2013-09-16), pages 415-418, XP032518998, ISSN: 1930-8833, DOI: 10.1109/ESSCIRC.2013.6649161 ISBN: 978-1-4799-0643-7 [extrait le 2013-10-28]

## Description

### DOMAINE TECHNIQUE ET ART ANTÉRIEUR

L'invention concerne le domaine des mémoires à accès aléatoire statique (SRAM) fonctionnant sur une très large plage de valeurs de tension d'alimentation, et par exemple utilisées dans des dispositifs électroniques portables tels que des smartphones (ou téléphones intelligents), tablettes numériques, ordinateurs portables, etc.

Pour les applications portables modernes dites à haute performance et à basse consommation, il est intéressant d'utiliser des circuits intégrés conçus pour fonctionner sur une très large plage de valeurs de tension d'alimentation afin de pouvoir adapter de manière dynamique la valeur de la tension d'alimentation de ces circuits en fonction de leur utilisation, et ainsi optimiser le rendement énergétique de ces circuits et réduire leur consommation électrique afin d'économiser du temps de batterie.

Dans les circuits intégrés numériques, les valeurs possibles de la tension d'alimentation de ces circuits sont généralement limitées par les mémoires de ces circuits. En effet, la variabilité des transistors CMOS présents dans les mémoires empêche celles-ci de fonctionner à une tension d'alimentation aussi basse que celle des éléments formant la logique des circuits intégrés car l'architecture des mémoires conduit à une dégradation de leurs performances plus importante que pour les éléments formant la logique lorsque la tension d'alimentation est réduite. Par exemple, en réduisant la tension d'alimentation, le temps d'accès des mémoires SRAM augmente plus rapidement que le temps de propagation des circuits logiques.

Dans les circuits intégrés, plusieurs types de mémoires sont utilisées. Plus la mémoire est proche de l'unité de calcul, plus ses performances et ses conditions de fonctionnement se rapprochent de celles de l'unité de calcul. Ainsi, la mémoire cache L1, qui est collée à l'unité de calcul, est généralement conçue à partir de cellules mémoires SRAM à 6 ou 8 transistors (appelées 6T ou 8T). Ces cellules mémoires sont développées pour atteindre le meilleur compromis des critères suivants :
- une bonne stabilité de l'information stockée,
- une facilité d'écriture,
- un courant de lecture (I_{CELL}) maximal pour avoir de bonnes performances,
- une taille de cellule raisonnable pour avoir une forte densité d'intégration associée à de faibles dégradations des performances dues à la métallisation de la cellule, et
- un courant en rétention (I_{OFF}) minimal pour minimiser la puissance statique consommée.

Les dispersions obtenues avec les technologies CMOS déca-nanométriques de 28 nm et moins empêchent toutefois de garantir ces critères avec un rendement élevé (de l'ordre de 5 à 6 sigmas, soit un taux d'erreur de l'ordre de 10⁻⁹). A basse tension, ces conditions sont d'autant plus difficiles à atteindre.

Parallèlement à ces considérations, la réduction des dimensions des composants électroniques nécessite de faire appel à des nouvelles technologies pour la réalisation de ces circuits intégrés. Ainsi, pour les noeuds technologiques 28 nm et en dessous, la technologie FDSOI (« Fully Depleted Silicon-On-Insulator », ou silicium sur isolant complètement déserté) permet d'améliorer le contrôle électrostatique et les dispersions des transistors MOS. De plus, la tension de seuil d'un transistor FDSOI peut être ajustée par dopage et polarisation en face arrière du transistor. Des caissons, ou « wells », de type N ou P peuvent être utilisés, à la fois pour les transistors NMOS et PMOS. Cette technologie FDSOI offre un moyen d'améliorer le rendement des circuits mémoires sans efforts de conception supplémentaires.

Le document « 6T SRAM design for Wide Voltage Range in 28nm FDSOI » de O. Thomas et al., SOI Conférence (SOI), 2012 IEEE International, 1-4 Oct. 2012, Napa, CA, pages 1 - 2, décrit une cellule mémoire 6T réalisée en technologie FDSOI 28 nm dont l'architecture mono-P-Well (un seul caisson de type P commun aux six transistors de la cellule mémoire) permet de réduire la valeur de la tension d'alimentation des transistors de la cellule, notamment en améliorant l'écriture. Cependant, l'optimisation de l'écriture et celle de la lecture restent dépendantes l'une de l'autre. Or, la réduction de la tension d'alimentation entraîne une baisse de la vitesse de lecture possible.

Le document « An Area-Conscious Low-Voltage-Oriented 8T-SRAM Design under DVS Environment » de Y. Morita et al., VLSI Circuits, 2007 IEEE Symposium on, 14-16 Juin 2007, Kyoto, JP, pages 256 - 257, décrit une cellule mémoire 8T qui comporte, par rapport à une cellule mémoire 6T, deux transistors supplémentaires formant le port de lecture de la cellule. Ce port de lecture permet de dé-corréler la lecture de l'écriture réalisée dans la cellule car lors d'une lecture, les deux transistors d'accès servant à l'écriture dans la cellule restent à l'état bloqué. Comme pour une cellule mémoire 6T, cette alternative peut être améliorée grâce à la technologie FDSOI. Toutefois, une baisse de la tension d'alimentation des transistors de la cellule entraîne tout de même une baisse de la vitesse de lecture pouvant être atteinte par une telle cellule mémoire.

De plus, pour les applications haute performance, que les cellules mémoires comportent 6 ou 8 transistors, le rendement des circuits mémoires est affecté par les fautes de timing, ou de synchronisme, en lecture et en écriture. Une faute de timing en lecture est due à un courant de lecture de cellule trop faible pour décharger suffisamment vite une ligne de bit dans le temps d'accès imparti. Une faute de timing en écriture est due au temps de commutation trop long d'une cellule mémoire pour mémoriser correctement un bit. Les fautes de timing en lecture peuvent également être engendrées par un temps d'écriture trop long car dans ce cas, la complétion du niveau logique « 1 », c'est-à-dire la transition du potentiel du noeud du niveau logique « 0 » vers le niveau logique « 1 » lors d'une écriture, n'est pas complète (la complétion pouvant se terminer pendant le cycle suivant), ce qui limite le courant de lecture lors de ce cycle suivant s'il s'agit d'une lecture car le potentiel dans le noeud est alors inférieur au potentiel correspondant au niveau logique « 1 ». Or, le nombre de cellules mémoires présentant de tels dysfonctionnement augmente lorsque la tension d'alimentation des cellules mémoires est réduite.

Au niveau de la matrice de cellules mémoires, des solutions de redondance de colonne ou de ligne de cellules ont été proposées pour palier à ces problèmes, comme décrit par exemple dans le document « Row/Column Redundancy to Reduce SRAM Leakage in Presence of Random Within-Die Delay Variation » de M. Goudarzi et al., Low Power Electronics and Design (ISLPED), 2008 ACM/IEEE International Symposium on, 11-13 Aug. 2008, Bangalore, pages 93 - 98. Ces redondances sont utilisées pour remplacer les colonnes ou lignes de cellules mémoires non fonctionnelles, c'est-à-dire les colonnes ou lignes de cellules dont une ou plusieurs cellules engendrent des fautes de timing en lecture et/ou en écriture. Le nombre de colonnes ou de lignes redondantes possible reste toutefois limité du fait qu'une certaine densité de la matrice doit tout de même être conservée. De plus, cette solution impose de reprogrammer les circuits d'accès à la matrice.

Il existe également des solutions basées sur des codes de correction d'erreurs, ou ECC. Elles associent des bits complémentaires à un mot qui permet de détecter et corriger éventuellement des erreurs. La programmation des bits complémentaires se fait via une logique d'encodage et la vérification par une logique de décodage. Les ECC sont très efficaces pour répondre aux erreurs « logicielles » (supposées de faible quantité) mais non adaptées pour les applications basse tension où le taux d'erreur augmente très rapidement.

Ces problèmes de fautes de timing en lecture et/ou en écriture engendrées par une baisse de la tension d'alimentation se retrouvent également pour des cellules mémoires SRAM comprenant des transistors autres que des transistors CMOS FDSOI, tels que des transistors TFET comme décrit dans le document « A novel Si-Tunnel FET based SRAM design for ultra low-power 0.3V VDD applications » de J. Singh et al., Proceedings of 15th Asia and South Pacific Design Automation Conference (ASP-DAC), pp. 181-186, janvier 2010.

Le document "BEIGNE E ET AL: "Ultra-Wide Voltage Range designs in Fully-Depleted Silicon-On-Insulator FETs",DESIGN, AUTOMATION & TEST IN EUROPE CONFERENCE & EXHIBITION, 2013, IEEE, 18 mars 2013, pages 613-618" décrit que le potentiel électrique du caisson de type N de la cellule de mémoire SRAM peut être ajusté pour gérer les performances et la consommation statique.

### EXPOSÉ DE L'INVENTION

Un but de la présente invention est de proposer un nouveau dispositif mémoire comportant des cellules mémoires SRAM, par exemple à base de transistors FDSOI, pouvant fonctionner sur une grande plage de valeurs de tension d'alimentation, et notamment fonctionner avec une faible tension d'alimentation en réduisant fortement l'impact d'une telle baisse de la tension d'alimentation sur la vitesse de lecture des cellules mémoires. Un but de la présente invention est également de réduire l'apparition de fautes de timing en lecture et en écriture des cellules mémoires même lorsqu'une faible tension d'alimentation est utilisée et cela sans qu'il soit nécessaire de faire appel à des solutions de redondance de cellules mémoires ou à des codes de correction d'erreurs.

Pour cela, la présente invention propose un dispositif mémoire selon la revendication 1.

Le dispositif mémoire selon l'invention permet d'optimiser le compromis efficacité énergétique / rendement des cellules mémoires. Il représente un moyen efficace notamment pour faire face à l'augmentation des dispersions des technologies CMOS déca-nanométriques (28 nm et en-dessous). Le dispositif mémoire peut ajuster le courant de lecture des cellules SRAM en jouant sur la polarisation de la face arrière des transistors du port de lecture et/ou des transistors de type P des cellules mémoires.

Par exemple, selon la valeur du potentiel électrique de polarisation sélectionnée et appliquée sur les deuxièmes caissons, la valeur de la tension de seuil des transistors des ports de lecture est modifiée. En modulant la valeur de la tension de seuil des transistors formant les ports de lecture des cellules, la vitesse de lecture des cellules est également modulée, ce qui permet de compenser les modifications de la vitesse de lecture engendrées par une modification de la valeur de la tension d'alimentation des cellules. Ainsi, il est possible de réduire la valeur de la tension d'alimentation des cellules mémoires, ce qui a pour effet d'augmenter le temps de lecture des cellules, cette augmentation du temps de lecture pouvant être compensée par une baisse de la tension de seuil des transistors des ports de lecture des cellules qui a pour conséquence d'accélérer le temps de décharge des lignes de bit de lecture à travers les transistors des ports de lecture.

Dans le cas de cellules mémoires dans lesquelles les transistors de type N comportent le premier caisson et les transistors de type P comportent le deuxième caisson, les performances en écriture et la stabilité sont améliorées en choisissant la valeur du potentiel électrique de polarisation sélectionnée et appliquée sur les deuxièmes caissons. Un compromis entre l'augmentation et la baisse de la tension de seuil est recherché pour améliorer la rétention et l'écriture.

Il est possible de contrôler globalement les potentiels de polarisation appliqués sur les deuxièmes caissons des cellules mémoires de la matrice, c'est-à-dire d'appliquer un même potentiel sur tous les deuxièmes caissons, ce qui permet d'ajuster les performances du dispositif mémoire en fonction des besoins de vitesse et de consommation du dispositif.

Il est également possible de contrôler localement les potentiels de polarisation appliqués sur les deuxièmes caissons des cellules mémoires de la matrice, c'est-à-dire de différencier, par exemple par colonnes ou groupes de colonnes de cellules mémoires, les potentiels de polarisation appliqués sur les deuxièmes caissons, ce qui permet par exemple d'augmenter le courant de lecture trop faible de certaines cellules mémoires sans affecter la consommation statique de l'ensemble du dispositif mémoire. Le contrôle local ainsi réalisé offre un moyen à la fois dense et ajustable (dans le temps) pour améliorer le rendement en lecture des cellules mémoires. De plus, grâce à une mémorisation des états de polarisation possibles des deuxièmes caissons, par exemple pour chaque colonne ou groupe de colonnes de cellules mémoires, la polarisation de la face arrière des transistors des ports de lecture et/ou de transistors de type P des cellules mémoires des colonnes peut être ajustable dans le temps en fonction des conditions d'utilisation de la mémoire.

Les moyens de polarisation du dispositif mémoire permettent de réaliser une commande commune de la polarisation d'un ou plusieurs groupes de cellules mémoires. Ce choix des niveaux des tensions de polarisation appliquées parmi les différents niveaux de polarisation mémorisés permet donc d'ajuster les valeurs des tensions de polarisation telles que les fautes temporelles en lecture et en écriture soient réduites. Les valeurs de polarisation ainsi choisies sont destinées à être appliquées sur les caissons des transistors des cellules mémoires durant une durée de fonctionnement du dispositif mémoire comprenant plusieurs cycles successifs de lecture / écriture dans les cellules mémoires.

Le dispositif mémoire selon l'invention représente également, les cellules mémoires étant réalisées avec des transistors FDSOI, une solution aux problèmes de variabilité, ou dispersion, du courant de lecture observés pour les transistors FDSOI. En effet, les problèmes de variabilité du courant de lecture des transistors sont d'autant plus importants que la tension d'alimentation de ces transistors est basse. Ainsi, en commandant indépendamment, par exemple pour chaque colonne ou chaque groupe de colonnes, la polarisation des transistors des ports de lecture et/ou des transistors de type P des cellules, il possible de choisir, pour les colonnes ou groupes de colonnes dont les cellules, ou une partie des cellules, sont les moins performantes et/ou impliquent des erreurs de lecture dans des conditions d'accès en lecture données, un potentiel de polarisation des deuxièmes caissons des transistors des ports de lecture et/ou des transistors de type P qui soit plus élevé que celui appliqué pour les autres colonnes ou groupes de colonnes de la matrice afin d'augmenter la valeur de la tension de seuil de ces transistors.

L'approche de l'invention est rendue possible grâce à la technologie FDSOI et l'architecture des cellules mémoire SRAM 6T ou 8T. Le dispositif mémoire peut ajuster le courant de lecture des cellules SRAM en jouant sur la polarisation de la face arrière des transistors du port de lecture, par exemple dans le cas de certaines cellules mémoires 8T, et/ou sur la polarisation de la face arrière des transistors de type P par exemple dans le cas de cellules mémoires 6T.

Le terme « caisson » désigne une portion de semi-conducteur dopé se trouvant sous l'oxyde enterré de chaque transistor FDSOI et formant le plan de masse (« Ground Plane » ou « Back Plane ») de chaque transistor FDSOI.

Les cellules mémoires peuvent être disposées les unes à côté des autres en formant plusieurs colonnes de cellules mémoires, et les deuxièmes caissons des cellules mémoires d'une même colonne peuvent être formés par une même portion de semi-conducteur dopé selon le deuxième type de conductivité. En outre, les premiers caissons des cellules mémoires d'une même colonne peuvent être formés par une même portion de semi-conducteur dopé selon le deuxième type de conductivité. Ainsi, un seul potentiel de polarisation peut être appliqué sur tous les deuxièmes caissons d'une même colonne de cellules mémoires et/ou sur tous les premiers caissons d'une même colonne de cellules mémoires.

De manière avantageuse, les troisièmes transistors des cellules mémoires de deux colonnes adjacentes ou de chaque groupe de deux colonnes adjacentes peuvent être disposés les uns à côté des autres tels que les deuxièmes caissons des cellules mémoires des deux colonnes adjacentes ou de chacun des groupes de deux colonnes adjacentes peuvent être formés par une même portion de semi-conducteur dopé selon le deuxième type de conductivité. Ainsi, un seul potentiel de polarisation peut être appliqué sur tous les deuxièmes caissons d'un même groupe de deux colonnes adjacentes de cellules mémoires.

De manière générale, les deuxièmes caissons des cellules mémoires de deux colonnes adjacentes peuvent être disposés les uns à côté des autres et être formés par une même portion de semi-conducteur dopé selon le deuxième type de conductivité, et/ou les premiers caissons des cellules mémoires de deux colonnes adjacentes peuvent être disposés les uns à côté des autres et être formés par une même portion de semi-conducteur dopé selon le premier type de conductivité. Ainsi, un seul potentiel de polarisation peut être appliqué sur tous les deuxièmes caissons de deux colonnes adjacentes de cellules mémoires et/ou un seul potentiel de polarisation peut être appliqué sur tous les premiers caissons de deux colonnes adjacentes de cellules mémoires.

Des premiers caissons ou des deuxièmes caissons de cellules mémoires de plusieurs colonnes distinctes peuvent être reliés électriquement entre eux par un substrat sur lequel la matrice de cellules mémoires est réalisée ou par un caisson profond réalisé dans le substrat, la conductivité du substrat ou dudit caisson profond étant similaire à celle desdits caissons reliés électriquement entre eux.

Les moyens de polarisation des deuxièmes caissons des cellules mémoires comportent:
- un circuit mémoire apte à mémoriser un état de polarisation des deuxièmes caissons des cellules mémoires pour chaque colonne ou groupe de deux colonnes adjacentes ;
- un circuit de sélection couplé au circuit mémoire, comportant plusieurs entrées sur lesquelles différentes valeurs de potentiel de polarisation sont destinées à être appliquées et apte à appliquer sur les deuxièmes caissons des cellules mémoires de chaque colonne ou groupe de deux colonnes adjacentes l'une desdites valeurs de potentiel de polarisation sélectionnée en fonction de l'état de polarisation mémorisé dans le circuit mémoire et associé à ladite colonne ou au dit groupe de deux colonnes adjacentes.

Le circuit de sélection peut comporter plusieurs multiplexeurs comportant chacun plusieurs entrées sur lesquelles lesdites valeurs de potentiel de polarisation sont destinées à être appliquées et une sortie reliée aux deuxièmes caissons des cellules mémoires d'une des colonnes ou d'un groupe de colonnes tel qu'un groupe de deux colonnes adjacentes.

Le circuit mémoire peut comporter au moins une cellule mémoire de chaque colonne et être tel que chacune desdites cellules mémoires puisse être apte à mémoriser un état de polarisation des deuxièmes caissons des cellules mémoires de la colonne dont fait partie ladite cellule mémoire ou que deux ou plusieurs desdites cellules mémoires puissent être aptes à mémoriser un état de polarisation des deuxièmes caissons des cellules mémoires d'un groupe de colonnes tel qu'un groupe de deux colonnes adjacentes dont font partie lesdites cellules mémoires.

Les moyens de polarisation des deuxièmes caissons des cellules mémoires peuvent comporter en outre :
- un circuit de test couplé à la matrice de cellules mémoires et apte à détecter si une ou plusieurs cellules mémoires ont une vitesse de lecture engendrant des erreurs de lecture ;
- un circuit de contrôle couplé au circuit de test et au circuit mémoire et apte à définir les états de polarisation destinés à être mémorisés dans le circuit mémoire en fonction de résultats fournis par le circuit de test.

Ainsi, il est par exemple possible de réduire la tension d'alimentation uniquement des cellules mémoires des colonnes ou de groupes de colonnes, tels que des groupes de deux colonnes adjacentes, dont aucune cellule n'engendre d'erreur en lecture.

Le premier type de conductivité peut correspondre au type P et le deuxième type de conductivité peut correspondre au type N.

Le dispositif mémoire peut comporter en outre des moyens de polarisation des premiers caissons des cellules mémoires aptes à appliquer un potentiel de polarisation nul sur les premiers caissons.

Selon un mode de réalisation particulier, chaque cellule mémoire peut comporter au moins quatre premiers transistors FDSOI formant deux inverseurs montés tête-bêche correspondant au point mémoire et deux deuxièmes transistors FDSOI formant au moins le port d'écriture, et dans lequel :
- chaque cellule mémoire comporte en outre deux troisièmes transistors FDSOI formant le port de lecture, les premiers et deuxièmes transistors FDSOI comportant le premier caisson, et les troisièmes transistors FDSOI comportant le deuxième caisson, ou
- les deuxièmes transistors FDSOI forment également le port de lecture, les transistors de type N parmi les premiers et deuxièmes transistors comportant le premier caisson, et les transistors de type P parmi les premiers et deuxièmes transistors comportant le deuxième caisson, ou
- chaque cellule mémoire comporte en outre deux troisièmes transistors FDSOI formant le port de lecture, les transistors de type N parmi les premiers et deuxièmes transistors comportant le premier caisson, et les troisièmes transistors et les transistors de type P parmi les premiers et deuxièmes transistors comportant le deuxième caisson.

L'invention porte également sur un procédé de polarisation d'un dispositif mémoire tel que décrit ci-dessus, comportant des étapes de :
- mémorisation d'un état de polarisation des deuxièmes caissons des cellules mémoires pour chaque colonne ou groupe de colonnes,
- sélection d'une valeur d'au moins un potentiel de polarisation des deuxièmes caissons en fonction de l'état de polarisation mémorisé dans le circuit mémoire et associé à ladite colonne ou au dit groupe de colonnes, et
- application dudit potentiel de polarisation sur les deuxièmes caissons de ladite colonne ou dudit groupe de colonnes.

Une valeur d'une tension d'alimentation des cellules mémoires du dispositif mémoire et la valeur dudit au moins un potentiel de polarisation peuvent être choisies en fonction d'une vitesse de lecture et d'une consommation électrique souhaitées du dispositif mémoire.

Le procédé peut être tel que :
- les cellules mémoires peuvent être disposées les unes à côté des autres en formant plusieurs colonnes de cellules mémoires, les deuxièmes caissons des cellules mémoires d'une même colonne pouvant être formés par une même portion de semi-conducteur dopé selon le deuxième type de conductivité, et/ou
- les troisièmes transistors des cellules mémoires de deux colonnes adjacentes ou de chaque groupe de deux colonnes adjacentes peuvent être disposés les uns à côté des autres tels que les deuxièmes caissons des cellules mémoires des deux colonnes adjacentes ou de chacun des groupes de deux colonnes adjacentes puissent être formés par une même portion de semi-conducteur dopé selon le deuxième type de conductivité,

le procédé pouvant comporter en outre une étape de mémorisation d'un état de polarisation des deuxièmes caissons des cellules mémoires pour chaque colonne ou groupe de deux colonnes adjacentes,
et l'étape de sélection peut réaliser une sélection d'une de différentes valeurs de potentiel de polarisation en fonction de l'état de polarisation mémorisé dans le circuit mémoire et associé à ladite colonne ou au dit groupe de deux colonnes adjacentes.

Le procédé peut comporter en outre une étape de test de la matrice de cellules mémoires détectant si une ou plusieurs cellules mémoires ont une vitesse de lecture engendrant des erreurs de lecture, et une étape de détermination des états de polarisation destinés à être mémorisés en fonction de résultats de l'étape de test.

La valeur du potentiel de polarisation appliqué sur au moins une partie des deuxièmes caissons peut être strictement positive.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement une cellule mémoire 8T d'un dispositif mémoire objet de la présente invention ;
- la figure 2 représente schématiquement une matrice de cellules mémoires d'un dispositif mémoire objet de la présente invention ;
- la figure 3 représente schématiquement un dispositif mémoire, objet de la présente invention, selon un mode de réalisation particulier;
- la figure 4 représente schématiquement une partie d'un dispositif mémoire, objet de la présente invention, selon une variante de réalisation ;
- la figure 5 représente schématiquement une cellule mémoire 6T d'un dispositif mémoire objet de la présente invention ;
- la figure 6 représente schématiquement une cellule mémoire 8T d'un dispositif mémoire objet de la présente invention ;
- la figure 7 représente schématiquement des caissons de cellules mémoires reliés électriquement entre eux par un caisson profond ;
- la figure 8 représente schématiquement des caissons de cellules mémoires de type 6T disposées au sein de trois colonnes adjacentes ;
- la figure 9 représente schématiquement des caissons de cellules mémoires de type 8T disposées au sein de trois colonnes adjacentes.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

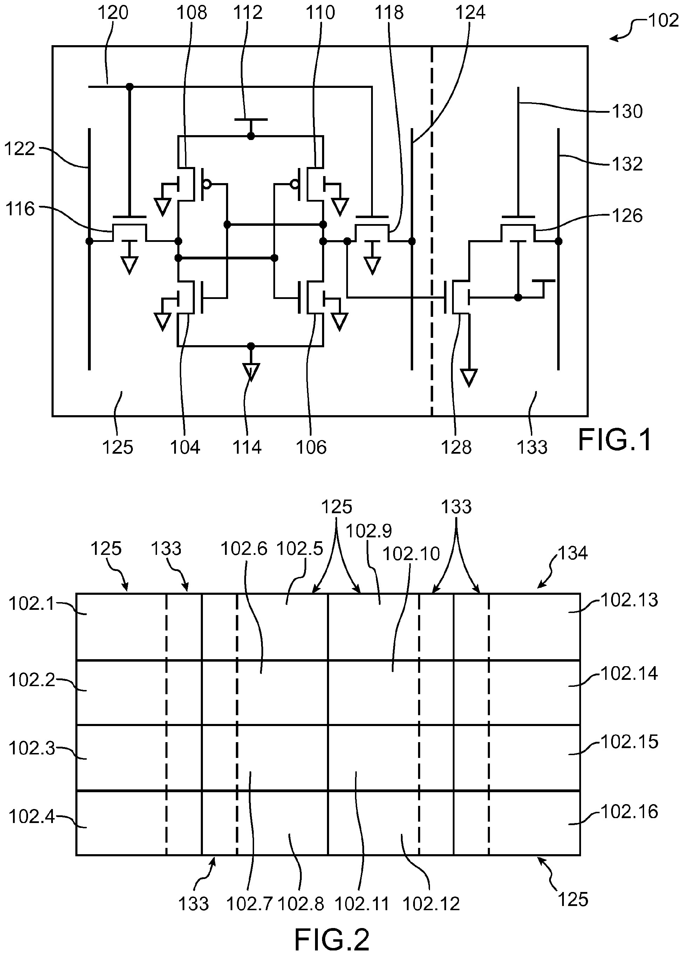

On se réfère tout d'abord à la figure 1 qui représente schématiquement une cellule mémoire 8T 102 d'un dispositif mémoire 100 selon un mode de réalisation particulier.

La cellule 102 comporte deux transistors NMOS 104, 106 et deux transistors PMOS 108, 110 formant ensemble deux inverseurs montés tête-bêche correspondant au point mémoire de la cellule 102, reliés à une borne d'alimentation 112 sur laquelle est appliqué un potentiel d'alimentation V_{DD}, par exemple égal à environ 1 V, et à un potentiel de référence 114 correspondant par exemple à la masse du dispositif 100. La cellule 102 comporte également deux transistors d'accès 116, 118, ici de type NMOS, comportant leur grille reliée à une ligne de mot d'écriture 120 sur laquelle un signal commandant une écriture dans la cellule 102 est destiné à être envoyé, leur drain relié à des lignes de bit d'écriture 122, 124 sur lesquelles circulent les données à mémoriser, et leur source reliée aux inverseurs. Les transistors 116 et 118 forment le port d'écriture de la cellule 102. Les transistors 104 à 110, 116 et 118 sont des transistors FDSOI comportant un premier caisson 125 de semi-conducteur dopé de type P (« P-Well ») qui forme le plan de masse de ces transistors. Ce premier caisson 125 est commun aux transistors 104 à 110, 116 et 118 de la cellule 102. Un potentiel électrique nul, par exemple celui de la masse du dispositif 100, est appliqué sur ce premier caisson 125.

La cellule 102 comporte également deux transistors NMOS 126, 128 formant un port de lecture de la cellule 102. Le transistor 126 comporte sa grille reliée à une ligne de mot de lecture 130, son drain relié à une ligne de bit de lecture 132 et sa source reliée au drain du transistor 128. La grille du transistor 128 est reliée au point mémoire de la cellule 102 et la source du transistor 128 est reliée au potentiel électrique de référence 114.

Préalablement à une lecture du bit mémorisé dans la cellule 102, le potentiel électrique de la ligne de bit de lecture 132 est pré-chargé à V_{DD}. Le transistor 126 est rendu ensuite passant via l'application d'un signal de commande de lecture, correspondant par exemple à une impulsion de potentiel égal à V_{DD}, sur sa grille depuis la ligne de mot de lecture 130. Selon la valeur du bit mémorisé dans la cellule 102, le transistor 128 est passant (bit à l'état « 1 ») ou non (bit à l'état « 0 »), ce qui entraîne une décharge plus ou moins importante du courant de lecture depuis la ligne de bit de lecture 132 à travers les transistors 126, 128 selon la valeur du bit mémorisé dans la cellule 102.

Les transistors 126 et 128 sont des transistors FDSOI comportant un deuxième caisson 133 commun de type N (N-Well) formant le plan de masse de ces transistors. Un potentiel électrique V_{NW} est appliqué sur le deuxième caisson 133 des transistors 126, 128, la valeur de ce potentiel étant comprise entre 0 et V_{DDH}, avec la valeur de V_{DDH} qui peut être supérieure ou égale à celle de V_{DD}, et fixée en fonction du mode de fonctionnement souhaité de la cellule 102, c'est-à-dire du compromis vitesse de lecture / consommation choisi, comme décrit plus loin. Sur la figure 1, les deux caissons 125 et 133 de types différents sont séparés symboliquement par des traits pointillés.

Le dispositif 100 comporte plusieurs cellules mémoires similaires à la cellule 102 représentée sur la figure 1 et disposées les unes à côté des autres en formant une ou plusieurs matrices de cellules. La figure 2 représente schématiquement seize cellules mémoires 102.1 - 102.16 similaires à la cellule 102 précédemment décrite et disposées en formant une matrice 4x4 référencée 134.

Les cellules mémoires 102.1-102.16 sont réalisées telles que les ports de lecture des cellules d'une même colonne de la matrice soient disposés les uns au-dessus des autres. Ainsi, les transistors 104 à 110, 116 et 118 des cellules d'une même colonne sont réalisés sur une même portion de semi-conducteur dopé P formant les premiers caissons des transistors de ces cellules, et les transistors 126 et 128 formant les ports de lecture des cellules d'une même colonne sont réalisés sur une portion de semi-conducteur dopé N formant les deuxièmes caissons des transistors de ces cellules.

La configuration représentée sur la figure 2 est avantageuse car les ports de lecture des cellules de deux colonnes adjacentes sont disposés les uns à côté des autres. Ainsi, les deuxièmes caissons des transistors 126 et 128 des cellules de ces deux colonnes sont formés par une même portion de semi-conducteur dopé N. Sur l'exemple de la figure 2, les transistors des ports de lecture des cellules 102.1 à 102.8 comportent une seule portion de semi-conducteur dopé N commune à ces cellules et formant les deuxièmes caissons des transistors 126 et 128 de ces cellules 102.1 - 102.8. Les transistors des ports de lecture des cellules 102.9 à 102.16 comportent une autre portion de semi-conducteur dopé N formant les deuxièmes caissons des transistors 126 et 128 de ces cellules 102.9 - 102.16. De plus, cette configuration permet également aux transistors 104 à 110, 116 et 118 des cellules de deux colonnes dont les ports de lecture ne sont pas disposés les uns à côté des autres de comporter une même portion de semi-conducteur dopé P formant les premiers caissons de ces transistors. Ainsi, sur l'exemple de la figure 2, les transistors 104 à 110, 116 et 118 des cellules 102.5 à 102.12 sont réalisés sur une même portion de semi-conducteur dopé P formant les premiers caissons de ces transistors.

Les caissons des transistors FDSOI des cellules mémoires correspondent à des régions de semi-conducteur fortement dopé, disposées sous les diélectriques enterrés (BOX) de ces transistors et qui permettent, selon la valeur du potentiel électrique de polarisation qui leur est appliqué, de modifier la valeur de la tension de seuil des transistors. En modulant la valeur de la tension de seuil des transistors formant les ports de lecture des cellules, la vitesse de lecture des cellules est également modulée, ce qui permet de compenser les modifications de la vitesse de lecture engendrées par une modification de la valeur de la tension d'alimentation des cellules. Ainsi, il est possible de réduire la valeur de la tension d'alimentation des transistors des cellules mémoires, ce qui a pour effet d'augmenter le temps de lecture des cellules, cette augmentation du temps de lecture pouvant être compensée par une baisse de la tension de seuil des transistors des ports de lecture des cellules qui a pour effet d'accélérer la décharge du courant depuis les lignes de bit de lecture à travers les transistors des ports de lecture.

Différents exemples de mode de fonctionnement des cellules mémoires 102 du dispositif 100, correspondant à différents compromis temps de lecture/consommation électrique des cellules, sont décrits ci-dessous.

Dans un premier mode de fonctionnement, lorsque les cellules mémoires 102 sont destinées à fonctionner le plus rapidement possible en lecture, sans chercher à réduire la consommation électrique de ces cellules, le potentiel d'alimentation V_{DD} de tous les transistors des cellules mémoires est choisi le plus élevé possible, par exemple égal à environ 1,3 V, et le potentiel V_{NW} de polarisation des deuxièmes caissons des transistors des ports de lecture des cellules est également choisi le plus élevé possible, c'est-à-dire égal à V_{DDH} qui est par exemple compris entre 2 et 3 V.

Dans un deuxième mode de fonctionnement, lorsque les cellules mémoires 102 sont destinées à fonctionner avec leur vitesse de lecture nominale, la valeur du potentiel d'alimentation V_{DD} des tous les transistors des cellules mémoires est abaissée par rapport à celle utilisée dans le premier mode de fonctionnement, et par exemple fixée entre à environ 0,6 V et 1,3 V, et par exemple égale à environ 1 V. La valeur du potentiel V_{NW} de polarisation des deuxièmes caissons des transistors des ports de lecture des cellules est également abaissée par rapport au premier mode de fonctionnement, et par exemple fixée entre environ V_{DD} et 0 V. Ainsi, la consommation des cellules mémoire est abaissée par rapport à celle du premier mode de fonctionnement, sans trop impacter la vitesse de lecture des cellules mémoires. En variante, il est possible de n'abaisser que la valeur de V_{DD} et de conserver une valeur élevée du potentiel V_{NW}.

Dans un troisième mode de fonctionnement dans lequel une très faible consommation des cellules mémoires est recherchée, le potentiel d'alimentation V_{DD} des transistors est par exemple fixé à une valeur égale à environ 0,6 V et le potentiel V_{NW} est fixé à 0V.

Dans un quatrième mode de fonctionnement dans lequel les cellules mémoires réalisent une rétention des valeurs des bits mémorisés, sans qu'une lecture ou une écriture soit réalisée, le potentiel d'alimentation V_{DD} est choisi le plus bas possible, par exemple égal à environ 0,4 V, et la valeur du potentiel V_{NW} de polarisation des deuxièmes caissons des transistors des ports de lecture des cellules est négative afin que les transistors de lecture soient polarisés en inverse, et par exemple comprise entre 0 et environ -300 mV.

Ainsi, pour des contraintes en termes de performances qui sont faibles ou lorsque les cellules mémoires sont dans un mode de mémorisation, ou rétention d'informations, les deuxièmes caissons des transistors des ports de lecture des cellules peuvent être polarisés avec un potentiel de polarisation nul, voir polarisés négativement, ce qui permet pour minimiser les courants de fuite à travers ces transistors. Réciproquement, pour des contraintes en termes de performances qui sont élevées, les deuxièmes caissons des transistors des ports de lecture des cellules peuvent être polarisés avec un potentiel de valeur égale à V_{DD} ou plus, augmentant ainsi la valeur du courant de lecture des cellules via la réduction de la tension de seuil des transistors des ports de lecture.

La valeur de la tension d'alimentation V_{DD} est la même pour tous les transistors des cellules mémoires 102 du dispositif 100.

Dans un premier exemple de réalisation, la valeur du potentiel V_{NW} appliqué sur les deuxièmes caissons des transistors des ports de lecture des cellules 102 peut être la même pour toutes les cellules d'une même matrice de cellules. Dans ce cas, le compromis temps de lecture/consommation est géré de manière globale pour toute la matrice de cellules 102.

Dans un deuxième exemple de réalisation, lorsque les ports de lecture des cellules de deux colonnes adjacentes sont disposés les uns à côté des autres, comme sur l'exemple de la figure 2, la polarisation des deuxièmes caissons des transistors des ports de lecture de telles cellules peut être commandée indépendamment pour chaque groupe de deux colonnes adjacentes. Par exemple, dans le cas représenté sur la figure 2, le potentiel de polarisation V_{NW} appliqué sur les deuxièmes caissons des transistors des ports de lecture des cellules 102.1 à 102.8 peut être choisi indépendamment de celui appliqué sur les deuxièmes caissons des transistors des ports de lecture des cellules 102.9 à 102.16.

Dans un troisième exemple de réalisation, lorsque les ports de lecture des cellules des colonnes ne sont pas disposés les uns à côté des autres, la polarisation des deuxièmes caissons des transistors des ports de lecture de telles cellules peut être commandée indépendamment pour chacune des colonnes.

Dans les deuxième et troisième exemples de réalisation ci-dessus, la polarisation indépendante pour chaque colonne ou chaque groupe de deux colonnes adjacentes représente une solution aux problèmes de variabilité, ou dispersion, du courant de lecture observés pour les transistors FDSOI. En effet, les problèmes de variabilité du courant de lecture des transistors sont d'autant plus importants que la tension d'alimentation de ces transistors est basse. Ainsi, en commandant indépendamment pour chaque colonne ou chaque groupe de deux colonnes adjacentes la polarisation des transistors des ports de lecture des cellules, il possible de choisir, pour les colonnes ou groupes de deux colonnes adjacentes dont les cellules, ou une partie des cellules, sont les moins performantes et/ou impliquent des erreurs de lecture dans des conditions d'accès en lecture données, un potentiel de polarisation des deuxièmes caissons des transistors des ports de lecture qui soit plus élevé que celui appliqué pour les autres colonnes ou groupes de colonnes afin de réduire la valeur de la tension de seuil de ces transistors.

Lorsque la polarisation des deuxièmes caissons des transistors des ports de lecture est gérée de manière globale pour toutes les cellules d'une même matrice (le potentiel de polarisation des deuxièmes caissons des transistors des ports de lecture étant le même pour toutes les cellules mémoire de la matrice) et que le dispositif comporte plusieurs matrices de cellules mémoires, le choix de la valeur du potentiel de polarisation des deuxièmes caissons des transistors des ports de lecture peut être réalisé au niveau matriciel, c'est-à-dire en choisissant cette valeur selon que la matrice en question comporte ou non des cellules moins performantes et/ou impliquant des erreurs de lecture dans des conditions d'accès en lecture données.

Dans les exemples précédemment décrits, les premiers caissons de type P des transistors 104 à 110, 116 et 118 des cellules mémoires 102, c'est-à-dire les transistors autres que ceux du port de lecture, peuvent être reliés à la masse, ce qui correspond à l'application d'un potentiel électrique de polarisation nul sur ces caissons. En variante, lorsque les deuxièmes caissons des transistors des ports de lecture sont polarisés négativement, les premiers caissons de type P peuvent également être polarisés négativement, par exemple à un même niveau de potentiel que celui appliqué sur les deuxièmes caissons des transistors des ports de lecture.

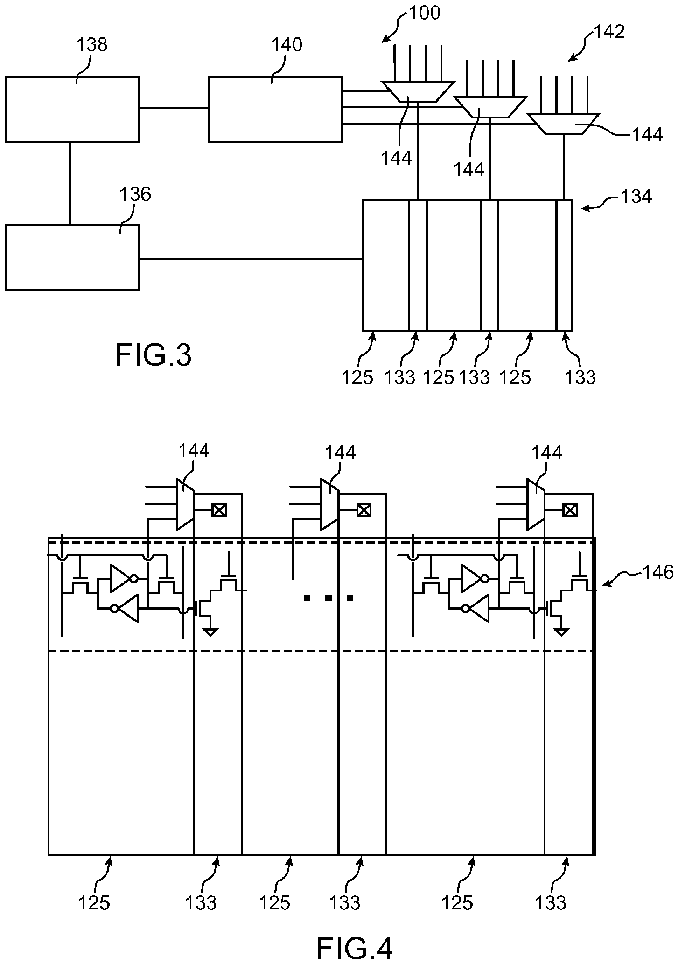

La figure 3 représente schématiquement le dispositif mémoire 100, et notamment les éléments du dispositif 100 contrôlant ou commandant la polarisation des deuxièmes caissons des transistors des ports de lecture des cellules mémoires 102 du dispositif 100.

Le dispositif 100 comporte une ou plusieurs matrices 134 de cellules mémoires 102 similaires à celle précédemment décrite en liaison avec la figure 1. Sur l'exemple de la figure 3, une seule matrice 134 de cellules mémoires 102 est représentée. De plus, seules trois colonnes de cellules mémoires 102 de la matrice 134 sont représentées.

La matrice 134 est couplée électriquement à un circuit de test 136 de type BIST, ou « Built-in-self Test », permettant de tester chacune des cellules mémoires 102 et de caractériser leurs performances.

Le circuit de test 136 est également couplé à un circuit de contrôle 138 qui, à partir des résultats fournis par le circuit de test 136, détermine les états de polarisation dans lesquels les plans de masse des transistors des ports de lecture des cellules 102 sont destinés à être polarisés. Le circuit de test 136 peut par exemple permettre de détecter les colonnes de cellules mémoires conduisant à des erreurs de lecture (dans des conditions d'accès en lecture données), et à partir de ces résultats, le circuit de contrôle 138 détermine quelles sont les colonnes de cellules défaillantes qui nécessitent de conserver une polarisation des deuxièmes caissons des transistors des ports de lecture avec un potentiel suffisamment élevé, par exemple à V_{DD}, pour réduire leur temps d'accès, les deuxièmes caissons des transistors des ports de lecture des autres colonnes pouvant être polarisés avec un plus faible potentiel, par exemple nul, afin de minimiser leur consommation.

Le circuit de contrôle 138 est relié à un circuit mémoire 140 dans lequel les états de polarisation des différentes colonnes déterminés par le circuit de contrôle 138 sont mémorisés. Un circuit de sélection 142, ici formé de plusieurs multiplexeurs 144, comporte des entrées de commande reliées au circuit mémoire 140. Chaque multiplexeur 144 du circuit de sélection 142 comporte plusieurs entrées (quatre sur l'exemple de la figure 3) sur lesquelles différents potentiels de polarisation, correspondant aux différents modes de fonctionnement possibles des cellules 102, sont appliqués. La sortie de chaque multiplexeur est reliée aux deuxièmes caissons des transistors des ports de lecture d'une des colonnes (ou groupe de deux colonnes adjacentes) de cellules mémoires de la matrice 130.

Ainsi, à partir des états de polarisation mémorisés dans le circuit mémoire 140, le circuit 142 applique l'un des potentiels de polarisation aux deuxièmes caissons des transistors des ports de lecture de chacune des colonnes de cellules 102 de la matrice 134. Les quatre niveaux de potentiels de polarisation appliqués sur les quatre entrées de chacun des multiplexeurs 144 correspondent par exemple aux potentiels correspondant aux quatre modes de fonctionnement précédemment décrits.

En variante, le circuit 142 peut correspondre à un seul multiplexeur recevant en entrée les différents niveaux de polarisation possibles des deuxièmes caissons des transistors des ports de lecture des cellules 102 et appliquant un même potentiel de polarisation aux deuxièmes caissons des transistors des ports de lecture des cellules de toutes les colonnes de la matrice 134.

Selon un mode de réalisation particulier, l'un des potentiels de polarisation reçus sur chacun des multiplexeurs 144 peut correspondre à celui d'un mode de fonctionnement appelé mode « standby » dans lequel la polarisation des deuxièmes caissons est ajustée de sorte à minimiser la consommation statique des cellules mémoires 102. La valeur de ce potentiel de polarisation est telle que la valeur des tensions de seuil des transistors comportant les deuxièmes caissons soit augmenté, et notamment une réduction de la valeur de la polarisation des caissons sur lesquels sont réalisés les transistors NMOS et une augmentation de la valeur de la polarisation des caissons sur lesquels sont réalisés les transistors PMOS. Il en résulte une certaine consommation dynamique due au changement de polarisation des caissons mais qui est associée à une forte réduction de la consommation statique des cellules mémoires. Il est donc avantageux d'utiliser ce mode si la mémoire reste dans celui-ci suffisamment longtemps de manière à ce que la baisse de la consommation statique des cellules mémoires compense la consommation dynamique engendrée par ce changement de mode.

En variante, il est également possible que le nombre de potentiels de polarisation appliqués en entrée du circuit 142 soit différent. Il est par exemple possible que seuls deux potentiels de polarisation soient appliqués en entrée du circuit 142, l'un pouvant correspondre à V_{DD} et l'autre correspondant à un potentiel électrique nul.

En variante, il est également possible que le circuit mémoire 140 soit formé par une partie des cellules 102 de la matrice 134. La figure 4 représente schématiquement une telle configuration, dans laquelle chacune des cellules 146 d'une des lignes de cellules de la matrice 134 est utilisée pour mémoriser l'état de polarisation dans lequel les deuxièmes caissons des transistors des ports de lecture des cellules de la colonne à laquelle appartient ladite cellule de cette ligne sont destinés à être polarisés. Le point mémoire de chacune des cellules 146 de cette ligne est relié à une entrée de commande d'un multiplexeur 144 qui comporte en outre deux autres entrées de données sur lesquelles deux niveaux différents de potentiels de polarisation sont appliqués, par exemple l'un correspond à V_{DD} et l'autre correspondant à un potentiel nul. La sortie de chaque multiplexeur 144 est reliée aux deuxièmes caissons des transistors des ports de lecture des cellules de la colonne correspondante tel que l'un des deux potentiels appliqués en entrée de chaque multiplexeur 144 soit appliqué sur ces deuxièmes caissons, en fonction de la valeur mémorisée dans la cellule mémoire correspondante.

Lorsque les ports de lecture de cellules mémoires de deux colonnes adjacentes sont disposés les uns à côté des autres et tels que les deuxièmes caissons des transistors de ces ports de lecture sont formés par une même portion de semi-conducteur dopé, les deux bits mémorisés par les deux cellules de la ligne dédiée à la mémorisation des états de polarisation de ces deux colonnes peuvent être utilisés pour commander un seul multiplexeur. Dans ce cas, il est possible de faire appel à un multiplexeur comportant quatre entrées afin que les deuxièmes caissons des transistors des ports de lecture de chaque groupe de deux colonnes puissent être polarisés selon l'un des quatre niveaux différents de polarisation possibles.

La ligne des cellules mémoires 146 utilisées pour mémoriser l'état de polarisation des deuxièmes caissons des transistors des ports de lecture des cellules mémoires correspond avantageusement à la ligne de cellules mémoires qui est positionnée à l'opposé de circuits d'entrées / sorties (qui comprennent des circuits de lecture et d'écriture) couplés à la matrice de cellules.

Des cellules mémoires dites de fin de ligne de bit sont disposées aux extrémités des colonnes de cellules de la matrice et peuvent servir à polariser les caissons des transistors de la matrice de cellules mémoires. Des lignes métalliques alignées dans le sens des colonnes de la matrice et chacune reliée aux deuxièmes caissons des transistors des ports de lectures des cellules d'une des colonnes ou d'un groupe de colonnes adjacentes peuvent être utilisées pour polariser ces deuxièmes caissons. La polarisation des premiers caissons des autres transistors des cellules de la matrice peut être réalisée de manière globale pour toute la matrice.

Faire appel à des cellules de la matrice 134 pour réaliser la mémorisation des états dans lesquels des transistors des ports de lecture sont destinés à être polarisés a pour avantage de pouvoir modifier dynamiquement l'état des ports de lecture, et également d'implémenter de manière très dense le dispositif 100.

En outre, les valeurs mémorisées dans les cellules peuvent être modifiées en fonction des besoins de l'application. Ainsi, il est possible que l'utilisateur choisisse directement les états de polarisation souhaités sans faire appel au circuit de test 136 et au circuit de contrôle 138.

Dans les exemples de réalisation précédemment décrits, les transistors 126 et 128 des ports de lecture des cellules mémoires 102 sont des transistors FDSOI de type NMOS. En variante, il est possible que ces transistors soient de type PMOS. Dans ce cas, la source du transistor 128 de chaque cellule 102 est reliée au potentiel électrique d'alimentation V_{DD}.

En outre, selon une autre variante de réalisation, que les transistors 126 et 128 soient de type NMOS ou PMOS, il est possible que les deuxièmes caissons 133 de ces transistors soient formés par des portions de semi-conducteur dopé P. Il est donc possible d'avoir des premiers caissons 125 de semi-conducteur dopé de type P et des deuxièmes caissons 133 de semi-conducteur dopé de type N, ou, dans une autre configuration, des premiers caissons 125 de semi-conducteur dopé de type N et des deuxièmes caissons 133 de semi-conducteur dopé de type P.

Enfin, selon une autre variante, il est possible que les potentiels de polarisation appliqués en entrée des multiplexeurs 144 soient différents d'une colonne à l'autre ou d'un groupe de deux colonnes adjacentes à l'autre.

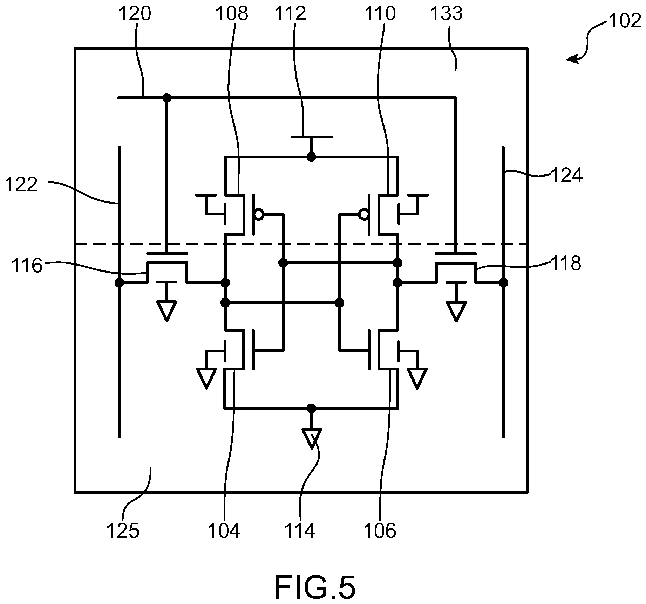

Les principes exposés ci-dessus pour les cellules mémoires 8T peuvent également s'appliquer à des cellules mémoires 6T. La figure 5 représente un exemple de réalisation d'une telle cellule mémoire 102 comportant six transistors.

Comme pour la cellule mémoire 8T, la cellule mémoire 6T comporte les deux transistors NMOS 104, 106 et les deux transistors PMOS 108, 110 formant ensemble deux inverseurs montés tête-bêche correspondant au point mémoire de la cellule 102, et reliés à la borne d'alimentation 112 et au potentiel de référence 114. La cellule 6T comporte également les deux transistors d'accès 116, 118 dont les grilles sont reliées à la ligne 120 servant ici à la fois de ligne de mot d'écriture et de ligne de mot de lecture. Les drains des transistors d'accès 116, 118 sont reliés aux lignes 122, 124 servant ici à la fois de lignes de bit d'écriture et de lignes de bit de lecture.

Les transistors correspondant à des transistors NMOS, ici les transistors 104, 106, 116 et 118, sont des transistors FDSOI comportant le premier caisson 125 de semi-conducteur dopé de type P qui forme le plan de masse de ces transistors. Un potentiel électrique nul, par exemple celui de la masse du dispositif 100, est appliqué sur ce premier caisson 125.

Les transistors correspondant à des transistors PMOS, ici les transistors 108 et 110, sont des transistors FDSOI comportant le deuxième caisson 133 de semi-conducteur dopé de type N qui forme le plan de masse de ces transistors. Un potentiel électrique V_{NW} est appliqué sur le deuxième caisson 133 des transistors 108, 110, la valeur de ce potentiel étant comprise entre 0 et V_{DDH} et fixée en fonction du mode de fonctionnement souhaité de la cellule 102, c'est-à-dire du compromis vitesse d'écriture/consommation choisi. Sur la figure 5, les deux caissons 125 et 133 de types différents sont séparés symboliquement par des traits pointillés. Une telle cellule mémoire est appelée cellule mémoire 6T RVT (« Regular Threshold Voltage »).

La disposition en colonne des cellules mémoires 102 précédemment décrite et permettant la mise en commun par colonne et par matrice des deuxièmes caissons 133 peut également s'appliquer pour les cellules mémoires 6T.

En variante, les transistors 116 et 118 peuvent être du même type que les transistors 108 et 110, c'est-à-dire de type PMOS dans l'exemple précédemment décrit. Dans ce cas, les lignes de bits 122, 124 sont pré-chargées à une tension basse, par exemple la masse.

En variante, que les transistors 116 et 118 soient du même type que celui des transistors 104 et 106 ou que celui des transistors 108 et 110, le premier caisson 125 peut comporter un semi-conducteur dopé de type N et le deuxième caisson 133 peut comporter un semi-conducteur dopé de type P. Une telle cellule mémoire est dans ce cas appelée cellule mémoire 6T LVT (« Low Threshold Voltage »).

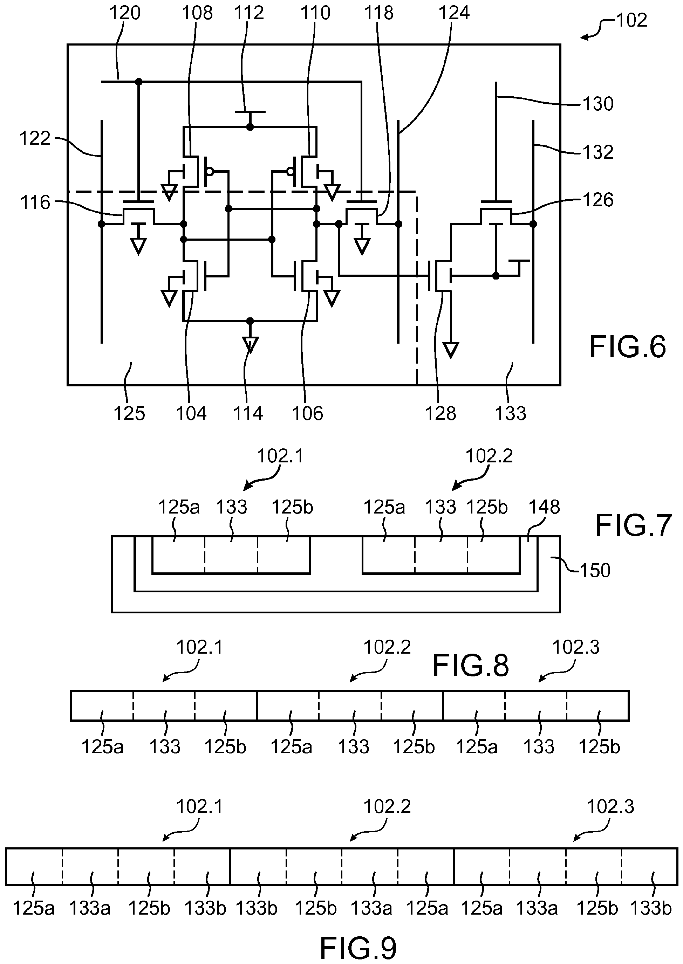

La figure 6 représente un autre exemple de réalisation d'une cellule mémoire 102 comportant huit transistors. Le fonctionnement des transistors de cette cellule mémoire 102 est similaire à celui de la cellule mémoire 102 précédemment décrite en liaison avec la figure 1.

Sur cet exemple, les transistors 104, 106, 116 et 118 de type N comportent le premier caisson 125 de semi-conducteur dopé de type P qui forme le plan de masse de ces transistors. Les transistors 108, 110, 126 et 128, c'est-à-dire les transistors (de type N) formant le port de lecture de la cellule 102 et les transistors de type P parmi ceux formant le point mémoire et le port d'écriture de la cellule 102, comportent le deuxième caisson 133 de semi-conducteur dopé de type N qui forme le plan de masse de ces transistors. Une telle cellule mémoire 102 correspond à une cellule mémoire 8T RVT, c'est-à-dire une cellule mémoire 6T RVT à laquelle un port de lecture, formé par les transistors 126 et 128, est ajouté.

En variante, le premier caisson 125 peut comporter du semi-conducteur dopé de type N et le deuxième caisson 133 peut comporter du semi-conducteur dopé de type P. Une telle cellule mémoire 102 correspond à une cellule mémoire 8T LVT, c'est-à-dire une cellule mémoire 6T LVT à laquelle un port de lecture, formé par les transistors 126 et 128, est ajouté.

Dans l'exemple de réalisation du dispositif 100 précédemment décrit en liaison avec la figure 2, des caissons adjacents de même conductivité de cellules mémoires appartenant à deux colonnes adjacentes sont formés par une même portion de semi-conducteur commune. D'autres types de liaison électrique entre les caissons de cellules mémoires appartenant à des colonnes adjacentes sont possibles.

La figure 7 représente un exemple dans lequel des liaisons électriques sont formées, grâce à un caisson profond, entre les différents caissons de deux cellules mémoires 6T LVT référencées 102.1 et 102.2 disposées l'une à côté de l'autre. La référence 125a désigne les caissons de type N des transistors 104 et 116 des deux cellules 102.1 et 102.2, la référence 133 désigne les caissons de type P des transistors 108 et 110 des deux cellules 102.1 et 102.2, et la référence 125b désigne les caissons de type N des transistors 106 et 118 des deux cellules 102.1 et 102.2. Les transistors des deux cellules 102.1 et 102.2 sont réalisés dans un caisson profond 148 (« Deep Well ») de type N lui-même formé par dopage dans un substrat 150 de type P. Ainsi, les caissons 125a, 125b des deux cellules mémoires 102.1 et 102.2 sont tous reliés électriquement entre eux par le caisson profond 148 de même conductivité que celles de ces caissons 125a, 125b.

De manière analogue, si les deux cellules mémoires 102.1 et 102.2 correspondent à des cellules mémoires 6T RVT (avec dans ce cas pour chaque cellule mémoire des caissons 125a, 125b de type P et des caissons 133 de type N), les caissons 125a, 125b des cellules 102.1 et 102.2 peuvent être tous reliés électriquement entre eux par le caisson profond 148 de type P formé dans le substrat 150 de type N.

Autant pour les cellules mémoires 6T LVT que pour les cellules mémoires 6T RVT, en l'absence du caisson profond 148, les caissons 133 des deux cellules mémoires 102.1 et 102.2 peuvent être reliés électriquement entre eux par le substrat 150 dont le semi-conducteur à une conductivité similaire à celle des caissons 133.

Ce principe de liaison électrique par un caisson profond ou directement par le substrat entre différents caissons de cellules mémoires appartenant à des colonnes adjacentes peut s'appliquer également aux cellules mémoires 8T précédemment décrites.

De plus, ce principe de liaison électrique par le substrat ou par un caisson profond formé dans le substrat peut être combiné avec le principe de former des liaisons électriques en disposant côte à côte des caissons de même conductivité et en formant ces caissons à partir d'une même portion de semi-conducteur dopé, comme précédemment décrit en liaison avec la figure 2, et permettre ainsi de réaliser des polarisations communes sur des caissons de cellules disposées sur plus de deux colonnes adjacentes.

La figure 8 représente schématiquement les caissons de trois cellules mémoires 102.1, 102.2 et 102.3 adjacentes deux à deux et de type 6T RVT réalisées dans un substrat de type P, sans la présence d'un caisson profond. Dans cette configuration, tous les caissons de type P 125a et 125b de toutes les cellules mémoires 102.1, 102.2 et 102.3 sont reliés électriquement entre eux par le substrat de type P. Ainsi, un même potentiel de polarisation peut être appliqué sur ces caissons 125a, 125b par l'intermédiaire du substrat, et des potentiels de polarisations distincts ou similaires peuvent être appliqués sur les caissons 133 de type N des différentes cellules 102.1, 102.2 et 102.3.

Une configuration analogue à celle représentée sur la figure 8 peut être réalisée à partir de cellules mémoires de type 6T LVT, réalisées dans un substrat de type P en présence d'un caisson profond de type N permettant de relier électriquement entre eux les caissons 125a, 125b de type N.

La figure 9 représente schématiquement les caissons de trois cellules mémoires 102.1, 102.2 et 102.3 adjacentes deux à deux et de type 8T RVT réalisées dans un substrat de type P, sans la présence d'un caisson profond. Dans cette configuration, tous les caissons de type P 125a et 125b de toutes les cellules mémoires 102.1, 102.2 et 102.3 sont reliés électriquement entre eux par le substrat de type P. Ainsi, un même potentiel de polarisation peut être appliqué sur ces caissons 125a, 125b par l'intermédiaire du substrat. Les cellules mémoires 102.1 et 102.2 sont outre réalisées telles que les caissons 133b, dans lesquels les transistors 126 et 128 des ports de lecture des cellules sont formés, de ces cellules soient adjacents. Ainsi, des potentiels de polarisations distincts ou similaires peuvent être appliqués sur les caissons 133a, dans lesquels les transistors 108 et 110 sont formés, et 133b de type N des différentes cellules 102.1, 102.2 et 102.3, avec toutefois un potentiel de polarisation commun appliqué sur les caissons 133b des cellules mémoires 102.1 et 102.2 en raison de la même portion de semi-conducteur dopé formant ces deux caissons.

Une configuration analogue à celle représentée sur la figure 9 peut être réalisée à partir de cellules mémoires de type 8T LVT réalisées dans un substrat de type P en présence d'un caisson profond de type N, tous les caissons de type N de toutes les cellules mémoires étant reliés électriquement entre eux par le caisson profond de type N.

Dans les exemples décrits ci-dessus, les conductivités du substrat et du caisson profond peuvent être respectivement N et P, ce qui modifie les liaisons électriques formées entre les caissons des cellules mémoires.

L'utilisation de caissons profonds pour relier électriquement entre eux plusieurs caissons de cellules mémoires peut également s'appliquer pour des cellules mémoires agencées en formant un dispositif mémoire de type 3D SRAM. De plus, le principe de réaliser des caissons de même conductivité de cellules adjacentes sous la forme d'un seul caisson de même conductivité, permettant d'appliquer un même potentiel de polarisation sur différents transistors de cellules mémoires adjacentes, peut également s'appliquer pour des cellules mémoires agencées en formant un dispositif mémoire de type 3D SRAM. Par exemple, dans le cas de cellules mémoires 3D SRAM comportant des transistors NMOS réalisés dans un premier niveau de semi-conducteur et des transistors PMOS réalisés dans un deuxième niveau de semi-conducteur disposé sur le premier niveau de semi-conducteur (ou inversement), les caissons du niveau inférieur de semi-conducteur peuvent être réalisés sous la forme d'un seul caisson sur lequel les caissons du niveau supérieur sont disposés et indépendants d'une colonne à l'autre.

Dans le cas de cellules 8T comportant deux transistors formant les ports de lecture des cellules, il est possible de réaliser ces cellules sous la forme d'une SRAM 3D dans laquelle ces transistors du port de lecture sont réalisés dans un niveau de semi-conducteur différentes du niveau des autres transistors des cellules. En alternant, d'une colonne à l'autre, le niveau dans lequel se trouvent ces transistors du port de lecture, il est possible d'obtenir un contrôle, indépendant d'une colonne à l'autre, des ports de lecture des cellules.

Dans les différents exemples et modes de réalisation décrits, les transistors utilisés dans les cellules mémoires sont des transistors CMOS FDSOI. Dans une variante qui ne fait pas partie de l'invention revendiquée, au moins une partie des transistors utilisés pour réaliser les cellules mémoires peuvent correspondre à des transistors TFET ou tout autre type de transistors adaptés pour former des cellules mémoires SRAM.

## Revendications

1. Dispositif mémoire (100) comportant au moins :
- une matrice (134) de cellules mémoires (102) de type SRAM disposées les unes à côté des autres en formant plusieurs colonnes de cellules mémoires (102), chaque cellule mémoire (102) comportant des transistors (104, 106, 108, 110, 116, 118, 126, 128) formant un point mémoire, un port de lecture et un port d'écriture et dans laquelle :
• les transistors formant le point mémoire et le port d'écriture comportent un premier caisson (125) de semi-conducteur dopé selon un premier type de conductivité et les transistors formant le port de lecture comportent un deuxième caisson (133) de semi-conducteur dopé selon un deuxième type de conductivité opposé au premier type de conductivité, ou
• les transistors de type N parmi les transistors de la cellule mémoire (102) comportent le premier caisson (125) et les transistors de type P parmi les transistors de la cellule mémoire (102) comportent le deuxième caisson (133), ou
• les transistors de type N parmi les transistors formant le point mémoire et le port d'écriture comportent le premier caisson (125), et les transistors formant le port de lecture ainsi que les transistors de type P parmi les transistors formant le point mémoire et le port d'écriture (102) comportent le deuxième caisson (133),
- des moyens (136, 138, 140, 142) de polarisation des deuxièmes caissons (133), aptes à sélectionner une valeur d'au moins un potentiel de polarisation des deuxièmes caissons (133) et à appliquer ledit potentiel de polarisation sur les deuxièmes caissons (133),
dans lequel les transistors (104, 106, 108, 110, 116, 118, 126, 128) sont de type fully depleted Silicon on insulator, FDSOI, et les premier et deuxième caissons (125, 133) sont disposés sous un diélectrique enterré des transistors (104, 106, 108, 110,116,118, 126, 128) et sont aptes à modifier une valeur de tension de seuil des transistors (104, 106, 108,110,116, 118,126, 128) selon une valeur d'un potentiel électrique de polarisation qui est destiné à leur être appliqué,
**caractérisé en ce que** le dispositif mémoire comprend:
• un circuit mémoire (140) apte à mémoriser un état de polarisation souhaité des deuxièmes caissons (133) des cellules mémoires (102) pour chaque colonne ou groupe de colonnes ;
• un circuit de sélection (142) couplé au circuit mémoire (140), comportant plusieurs entrées sur lesquelles différentes valeurs de potentiel de polarisation sont destinées à être appliquées et apte à appliquer localement de manière différenciée, par colonnes ou par groupes de colonnes, sur les deuxièmes caissons (133) des cellules mémoires (102) de chaque colonne ou groupe de colonnes l'une desdites valeurs de potentiel de polarisation sélectionnée en fonction de l'état de polarisation souhaité mémorisé dans le circuit mémoire (140) et associé à ladite colonne ou au dit groupe de colonnes.

2. Dispositif mémoire (100) selon la revendication 1, dans lequel, lorsque les transistors de type N parmi les transistors de la cellule mémoire (102) comportent le premier caisson (125) et les transistors de type P parmi les transistors de la cellule mémoire (102) comportent le deuxième caisson (133), ou lorsque les transistors de type N parmi les transistors formant le point mémoire et le port d'écriture comportent le premier caisson (125) et les transistors formant le port de lecture ainsi que les transistors de type P parmi les transistors formant le point mémoire et le port d'écriture (102) comportent le deuxième caisson (133), les deuxièmes caissons (133) des cellules mémoires (102) d'une même colonne sont formés par une même portion de semi-conducteur dopé selon le deuxième type de conductivité, et/ou dans lequel les premiers caissons (125) des cellules mémoires (102) d'une même colonne sont formés par une même portion de semi-conducteur dopé selon le premier type de conductivité.

3. Dispositif mémoire (100) selon la revendication 2, dans lequel les deuxièmes caissons (133) des cellules mémoires (102) de deux colonnes adjacentes sont disposés les uns à côté des autres et formés par une même portion de semi-conducteur dopé selon le deuxième type de conductivité, et/ou dans lequel les premiers caissons (125) des cellules mémoires (102) de deux colonnes adjacentes sont disposés les uns à côté des autres et formés par une même portion de semi-conducteur dopé selon le premier type de conductivité.

4. Dispositif mémoire (100) selon l'une des revendications précédentes, dans lequel des premiers caissons (125) ou des deuxièmes caissons (133) de cellules mémoires (102) de plusieurs colonnes distinctes sont reliés électriquement entre eux par un substrat (150) sur lequel la matrice de cellules mémoires (102) est réalisée ou par un caisson profond (148) réalisé dans le substrat (150), la conductivité du substrat (150) ou dudit caisson profond (148) étant similaire à celle desdits caissons reliés électriquement entre eux.

5. Dispositif mémoire (100) selon l'une des revendications précédentes, dans lequel le circuit de sélection (142) comporte plusieurs multiplexeurs (144) comprenant chacun plusieurs entrées sur lesquelles lesdites valeurs de potentiel de polarisation sont destinées à être appliquées et une sortie reliée aux deuxièmes caissons (133) des cellules mémoires (102) d'une des colonnes ou d'un groupe de colonnes.

6. Dispositif mémoire (100) selon l'une des revendications précédentes, dans lequel le circuit mémoire (140) comporte au moins une cellule mémoire (146) de chaque colonne et est tel que chacune desdites cellules mémoires (146) soit apte à mémoriser un état de polarisation souhaité des deuxièmes caissons (133) des cellules mémoires (102) de la colonne dont fait partie ladite cellule mémoire (146) ou que plusieurs desdites cellules mémoires (146) soient aptes à mémoriser un état de polarisation souhaité des deuxièmes caissons (133) des cellules mémoires (102) d'un groupe de colonnes dont font partie lesdites cellules mémoires (146).

7. Dispositif mémoire (100) selon l'une des revendications précédentes, dans lequel les moyens de polarisation des deuxièmes caissons (133) des cellules mémoires (102) comportent en outre :
- un circuit de test (136) couplé à la matrice (134) de cellules mémoires (102) et apte à détecter si une ou plusieurs cellules mémoires (102) ont une vitesse de lecture engendrant des erreurs de lecture ;
- un circuit de contrôle (138) couplé au circuit de test (136) et au circuit mémoire (140) et apte à définir les états de polarisation souhaités destinés à être mémorisés dans le circuit mémoire (140) en fonction de résultats fournis par le circuit de test (136).

8. Dispositif mémoire (100) selon l'une des revendications précédentes, dans lequel le premier type de conductivité correspond au type P et le deuxième type de conductivité correspond au type N.

9. Dispositif mémoire (100) selon l'une des revendications précédentes, comportant en outre des moyens de polarisation des premiers caissons (125) des cellules mémoires (102) aptes à appliquer un potentiel de polarisation nul sur les premiers caissons (125).

10. Dispositif mémoire (100) selon l'une des revendications précédentes, dans lequel chaque cellule mémoire (102) comporte au moins quatre premiers transistors FDSOI (104, 106, 108, 110) formant deux inverseurs montés tête-bêche correspondant au point mémoire et deux deuxièmes transistors FDSOI (116, 118) formant au moins le port d'écriture, et dans lequel :
- chaque cellule mémoire (102) comporte en outre deux troisièmes transistors FDSOI (126, 128) formant le port de lecture, les premiers (104, 106, 108, 110) et deuxièmes (116, 118) transistors FDSOI comportant le premier caisson (125), et les troisièmes transistors FDSOI (126, 128) comportant le deuxième caisson (133), ou
- les deuxièmes transistors FDSOI (116, 118) forment également le port de lecture, les transistors de type N parmi les premiers (104, 106, 108, 110) et deuxièmes (116, 118) transistors comportant le premier caisson (125), et les transistors de type P parmi les premiers (104, 106, 108, 110) et deuxièmes (116, 118) transistors comportant le deuxième caisson (133), ou
- chaque cellule mémoire (102) comporte en outre deux troisièmes transistors FDSOI (126, 128) formant le port de lecture, les transistors de type N parmi les premiers (104, 106, 108, 110) et deuxièmes (116, 118) transistors comportant le premier caisson (125), et les troisièmes transistors (126, 128) et les transistors de type P parmi les premiers (104, 106, 108, 110) et deuxièmes (116, 118) transistors comportant le deuxième caisson (133).

11. Procédé de polarisation d'un dispositif mémoire (100) selon l'une des revendications précédentes, comportant des étapes de :
- mémorisation d'un état de polarisation souhaité des deuxièmes caissons (133) des cellules mémoires (102) pour chaque colonne ou groupe de colonnes,
- sélection d'une valeur d'au moins un potentiel de polarisation des deuxièmes caissons (133) en fonction de l'état de polarisation souhaité mémorisé dans le circuit mémoire (140) et associé à ladite colonne ou au ditgroupe de colonnes, et
- application dudit potentiel de polarisation sur les deuxièmes caissons (133) de ladite colonne ou dudit groupe de colonnes.

12. Procédé selon la revendication 11, dans lequel une valeur d'une tension d'alimentation des cellules mémoires (102) du dispositif mémoire (100) et la valeur dudit au moins un potentiel de polarisation sont choisies en fonction d'une vitesse de lecture et d'une consommation électrique souhaitées du dispositif mémoire (100).

13. Procédé selon l'une des revendications 11 ou 12, comportant en outre une étape de test de la matrice (134) de cellules mémoires (102) détectant si une ou plusieurs cellules mémoires (102) ont une vitesse de lecture engendrant des erreurs de lecture, et une étape de détermination des états de polarisation souhaités destinés à être mémorisés en fonction de résultats de l'étape de test.

14. Procédé selon l'une des revendications 11 à 13, dans lequel la valeur du potentiel de polarisation appliqué sur au moins une partie des deuxièmes caissons (133) est strictement positive.

## Patentansprüche

1. Speichervorrichtung (100), mindestens beinhaltend:
- eine Matrix (134) von Speicherzellen (102) vom SRAM-Typ, die nebeneinander angeordnet sind, und mehrere Spalten von Speicherzellen (102) bilden, wobei jede Speicherzelle (102), die Transistoren (104, 106, 108, 110, 116, 118, 126, 128) beinhaltet, einen Speicherpunkt, einen Lese-Port und einen Schreib-Port bildet, und wobei:
• die Transistoren, die den Speicherpunkt und den Schreib-Port bilden, ein erstes Halbleitergehäuse (125) beinhalten, das gemäß einem ersten Leitfähigkeitstyp dotiert ist, und die Transistoren, die den Lese-Port bilden, ein zweites Halbleitergehäuse (133) beinhalten, das gemäß einem zweiten Leitfähigkeitstyp dotiert ist, der dem ersten Leitfähigkeitstyp entgegengesetzt ist, oder
• die Transistoren vom N-Typ unter den Transistoren der Speicherzelle (102) das erste Gehäuse (125) beinhalten, und die Transistoren vom P-Typ unter den Transistoren der Speicherzelle (102) das zweite Gehäuse (133) beinhalten, oder
• die Transistoren vom N-Typ unter den Transistoren, die den Speicherpunkt und den Schreib-Port bilden, das erste Gehäuse (125) beinhalten, und die Transistoren, die den Lese-Port bilden, sowie die Transistoren vom P-Typ unter den Transistoren, die den Speicherpunkt und den Schreib-Port (102) bilden, das zweite Gehäuse (133) beinhalten,
- Mittel (136, 138, 140, 142) zur Polarisation des zweiten Gehäuses (133) geeignet sind, einen Wert mindestens eines Polarisationspotentials der zweiten Gehäuse (133) auszuwählen und das Polarisationspotential auf die zweiten Gehäuse (133) anzuwenden,
wobei die Transistoren (104, 106, 108, 110, 116, 118, 126, 128) vom Typ vollständig verarmtes Silizium auf einem Isolator, FDSOI, sind, und das erste und zweite Gehäuse (125, 133) unter einem verdecktem Dielektrikum von Transistoren (104, 106, 108, 110, 116, 118, 126, 128) angeordnet sind, und geeignet, einen Schwellenspannungswert von Transistoren (104, 106, 108, 110, 116, 118, 126, 128) zu modifizieren gemäß einem Wert eines elektrischen Polarisationspotentials, das dazu bestimmt ist, an sie angewendet zu werden,
**dadurch gekennzeichnet, dass** die Speichervorrichtung umfasst:
• eine Speicherschaltung (140), die geeignet ist, einen gewünschten Polarisationszustand der zweiten Gehäuse (133) der Speicherzellen (102) für jede Spalte oder Spaltengruppe zu speichern;
• eine Auswahlschaltung (142), die mit der Speicherschaltung (140) gekoppelt ist, mehrere Eingänge beinhaltend, an denen verschiedene Polarisationspotentialwerte bestimmt sind, um angewendet zu werden, und geeignet, um, lokal differenziert, pro Spalte oder Spaltengruppen, auf die zweiten Gehäuse (133) der Speicherzellen (102) jeder Spalte oder Spaltengruppe, einen der Polarisationspotentialwerte anzuwenden, der in Abhängigkeit vom gewünschten Polarisationszustand ausgewählt und in der Speicherschaltung (140) gespeichert wird und der Spalte oder Spaltengruppe zugeordnet ist.

2. Speichervorrichtung (100) nach Anspruch 1, wobei, wenn die Transistoren vom N-Typ unter den Transistoren der Speicherzelle (102) das erste Gehäuse (125) beinhalten, und die Transistoren vom P-Typ unter den Transistoren der Speicherzelle (102) das zweite Gehäuse (133) beinhalten, oder wenn die Transistoren vom N-Typ unter den Transistoren, die den Speicherpunkt und den Schreib-Port bilden, das erste Gehäuse (125) beinhalten und die Transistoren, die den Lese-Port bilden, sowie die Transistoren vom P-Typ unter den Transistoren, die den Speicherpunkt und den Schreib-Port (102) bilden, das zweite Gehäuse (133) beinhalten, wobei die zweiten Gehäuse (133) der Speicherzellen (102) einer gleichen Spalte durch einen gleichen Abschnitt eines Halbleiters gebildet sind, der gemäß dem zweiten Leitfähigkeitstyp dotiert ist, und/oder wobei die ersten Gehäuse (125) der Speicherzellen (102) einer gleichen Spalte durch einen gleichen Abschnitt eines Halbleiters gebildet sind, der gemäß dem ersten Leitfähigkeitstyp dotiert ist.

3. Speichervorrichtung (100) nach Anspruch 2, wobei die zweiten Gehäuse (133) der Speicherzellen (102) von zwei benachbarten Spalten nebeneinander angeordnet und durch einen gleichen Abschnitt eines Halbleiters gebildet sind, der gemäß dem zweiten Leitfähigkeitstyp dotiert ist, und/oder wobei die ersten Gehäuse (125) der Speicherzellen (102) von zwei benachbarten Spalten nebeneinander angeordnet und durch einen gleichen Abschnitt eines Halbleiters gebildet sind, der gemäß dem ersten Leitfähigkeitstyp dotiert ist.

4. Speichervorrichtung (100) nach einem der vorhergehenden Ansprüche, wobei erste Gehäuse (125) oder zweite Gehäuse (133) von Speicherzellen (102) von mehreren separaten Spalten durch ein Substrat (150) elektrisch miteinander verbunden sind, auf dem die Matrix der Speicherzellen (102) erstellt ist, oder durch ein tiefes Gehäuse (148), das im Substrat (150) erstellt ist, wobei die Leitfähigkeit des Substrats (150) oder des tiefen Gehäuses (148) der der elektrisch miteinander verbunden Gehäuse ähnlich ist.

5. Speichervorrichtung (100) nach einem der vorhergehenden Ansprüche, wobei die Auswahlschaltung (142) mehrere Multiplexer (144) beinhaltet, die jeweils mehrere Eingänge umfassen, an denen die Polarisationspotentialwerte bestimmt sind, um angewendet zu werden, und einen Ausgang, der mit den zweiten Gehäusen (133) der Speicherzellen (102) einer der Spalten oder einer Spaltengruppe verbunden ist.

6. Speichervorrichtung (100) nach einem der vorhergehenden Ansprüche, wobei die Speicherschaltung (140) mindestens eine Speicherzelle (146) jeder Spalte beinhaltet, und derart ist, dass jede der Speicherzellen (146) geeignet ist, einen gewünschten Polarisationszustand der zweiten Gehäuse (133) der Speicherzellen (102) der Spalte zu speichern, zu der die Speicherzelle (146) gehört, oder dass mehrere der Speicherzellen (146) geeignet sind, einen gewünschten Polarisationszustand der zweiten Gehäuse (133) der Speicherzellen (102) einer Spaltengruppe zu speichern, zu der die Speicherzellen (146) gehören.

7. Speichervorrichtung (100) nach einem der vorhergehenden Ansprüche, wobei die Polarisationsmittel der zweiten Gehäuse (133) der Speicherzellen (102) ferner beinhalten:
- eine Testschaltung (136), die mit der Matrix (134) von Speicherzellen (102) gekoppelt ist und geeignet, um zu erkennen, ob eine oder mehrere Speicherzellen (102) eine Lesegeschwindigkeit haben, die zu Lesefehlern führt;
- eine Kontrollschaltung (138), die mit der Testschaltung (136) und der Speicherschaltung (140) gekoppelt ist, und geeignet, um die gewünschten Polarisationszustände zu definieren, die bestimmt sind, in der Speicherschaltung (140) in Abhängigkeit von den von der Testschaltung (136) gelieferten Ergebnissen gespeichert zu werden.

8. Speichervorrichtung (100) nach einem der vorhergehenden Ansprüche, wobei der erste Leitfähigkeitstyp dem P-Typ entspricht und der zweite Leitfähigkeitstyp dem N-Typ entspricht.

9. Speichervorrichtung (100) nach einem der vorhergehenden Ansprüche, ferner Polarisationsmittel der ersten Gehäuse (125) der Speicherzellen (102) beinhaltend, die geeignet sind, um ein Null-Polarisationspotential an die ersten Gehäuse (125) anzuwenden.

10. Speichervorrichtung (100) nach einem der vorhergehenden Ansprüche, wobei jede Speicherzelle (102) mindestens vier erste FDSOI-Transistoren (104, 106, 108, 110) beinhaltet, die zwei entgegengesetzt montierte Umschalter bilden, die dem Speicherpunkt entsprechen, und zwei zweite FDSOI-Transistoren (116, 118), die mindestens den Schreib-Port bilden, und wobei:
- jede Speicherzelle (102) ferner zwei dritte FDSOI-Transistoren (126, 128) beinhaltet, die den Lese-Port bilden, wobei die ersten (104, 106, 108, 110) und zweiten (116, 118) FDSOI-Transistoren das erste Gehäuse (125) beinhalten, und die dritten FDSOI-Transistoren (126, 128) das zweite Gehäuse (133) beinhalten, oder
- die zweiten FDSOI-Transistoren (116, 118) ebenfalls den Lese-Port bilden, wobei die Transistoren vom N-Typ, unter den ersten (104, 106, 108, 110) und zweiten (116, 118) Transistoren, das erste Gehäuse (125) beinhalten, und die Transistoren vom P-Typ, unter den ersten (104, 106, 108, 110) und zweiten (116, 118) Transistoren, das zweite Gehäuse (133) beinhalten, oder
- jede Speicherzelle (102) ferner zwei dritte FDSOI-Transistoren (126, 128) beinhaltet, die den Lese-Port bilden, wobei die Transistoren vom N-Typ, unter den ersten (104, 106, 108, 110) und zweiten (116, 118) Transistoren, das erste Gehäuse (125) beinhalten, und die dritten Transistoren (126, 128) und die Transistoren vom P-Typ, unter den ersten (104, 106, 108, 110) und zweiten (116, 118) Transistoren, das zweite Gehäuse (133) beinhalten.

11. Polarisationsverfahren einer Speichervorrichtung (100) nach einem der vorhergehenden Ansprüche, die Schritte beinhaltend:
- Speichern eines gewünschten Polarisationszustands der zweiten Gehäuse (133) der Speicherzellen (102) für jede Spalte oder Spaltengruppe,
- Auswahl eines Wertes mindestens eines Polarisationspotentials der zweiten Gehäuse (133) in Abhängigkeit vom gewünschten Polarisationszustand, der in der Speicherschaltung (140) gespeichert und der Spalte oder der Spaltengruppe zugeordnet ist, und
- Anwendung des Polarisationspotentials auf die zweiten Gehäuse (133) der Spalte oder der Spaltengruppe.

12. Verfahren nach Anspruch 11, wobei ein Wert einer Versorgungsspannung der Speicherzellen (102) der Speichervorrichtung (100) und der Wert des mindestens eines Polarisationspotentials in Abhängigkeit von einer gewünschten Lesegeschwindigkeit und des Stromverbrauchs der Speichervorrichtung (100) ausgewählt werden.

13. Verfahren nach einem der Ansprüche 11 oder 12, ferner einen Schritt zum Testen der Matrix (134) der Speicherzellen (102) beinhaltend, der erkennt, ob eine oder mehrere Speicherzellen (102) eine Lesegeschwindigkeit haben, die zu Lesefehlern führt, und einen Schritt zum Ermitteln der gewünschten Polarisationszustände, die bestimmt sind, in Abhängigkeit der Ergebnisse des Testschritts gespeichert zu werden.

14. Verfahren nach einem der Ansprüche 11 bis 13, wobei der Wert des Polarisationspotentials, das auf mindestens einen Teil der zweiten Gehäuse (133) angewendet wird, streng positiv ist.

## Claims

1. Memory device (100) including at least:
- a matrix (134) of memory cells (102) of the SRAM type positioned next one to another while forming several columns of memory cells (102), each memory cell (102) including transistors (104, 106, 108, 110, 116, 118, 126, 128) forming a memory point, a read port and a write port, and in which:
• the transistors forming the memory point and the write port include a first semiconductor well (125) doped according to a first type of conductivity and the transistors forming the read port include a second semiconductor well (133) doped according to a second type of conductivity opposite the first type of conductivity, or
• the N-type transistors among the transistors of the memory cell (102) include the first well (125) and the P-type transistors among the transistors of the memory cell (102) includes the second well (133), or
• the N-type transistors among the transistors forming the memory point and the write port include the first well (125), and the transistors forming the read port and the P-type transistors from among the transistors forming the memory point and the write port (102) include the second well (133),
- polarization means (136, 138, 140, 142) for the second wells (133), able to select a value of at least one polarization potential of the second wells (133) and to apply said polarization potential on the second wells (133),
wherein the transistors (104, 106, 108, 110, 116, 118, 126, 128) are of the fully depleted Silicon on insulator, FDSOI, and the first and second wells (125, 133) are arranged under a buried dielectric of the transistors (104, 106, 108, 110, 116, 118, 126, 128) and are able to modify a value of threshold voltage of transistors (104, 106, 108, 110, 116, 118, 126, 128) according to a value of an electric potential which is intended to be applied on them,
**characterized in that** the memory device comprises:
• a memory circuit (140) able to store a polarization state of the second wells (133) of the memory cells (102) for each column or group of columns;
• a selection circuit (142) coupled to the memory circuit (140), including several inputs on which different polarization potential values are intended to be applied and able to apply, locally in a differentiated way, by columns or groups of columns, on the second wells (133) of the memory cells (102) of each column or group of columns, one of said polarization potential values selected as a function of the polarization state stored in the memory circuit (140) and associated with said column or said group of columns.

2. Memory device (100) according to claim 1, wherein, when the N type transistors among the transistors of the memory cell (102) comprise the first well (125) and the P type transistors among the transistors of the memory cell (102) comprise the second well (133), or when the N type transistors among the transistor forming the memory point and the write port comprise the first well (125) and the transistors forming the read port and the P-type transistors from among the transistors forming the memory point and the write port (102) include the second well (133), the second wells (133) of the memory cells (102) of a same column are formed by a same semiconductor portion doped according to the second type of conductivity, and/or wherein the first wells (125) of the memory cells (102) of a same column are formed by a same semiconductor portion doped according to the first type of conductivity.

3. Memory device (100) according to claim 2, wherein the second wells (133) of the memory cells (102) of two adjacent columns are positioned next to one another and formed by a same semiconductor portion doped according to the second type of conductivity, and/or wherein the first wells (125) of the memory cells (102) of two adjacent columns are positioned next to one another and formed by a same semiconductor portion doped according to the first type of conductivity.

4. Memory device (100) according to one of preceding claims, wherein first wells (125) or second wells (133) of memory cells (102) of several separate columns are electrically connected to one another by a substrate (150) on which the matrix of memory cells (102) is produced or by a deep well (148) produced in the substrate (150), the conductivity of the substrate (150) or of the deep well (148) being similar to that of said wells electrically connected to one another.

5. Memory device (100) according to one of previous claims, wherein the selection circuit (142) includes several multiplexers (144) each comprising several inputs on which said polarization potential values are intended to be applied and an output connected to the second wells (133) of the memory cells (102) of one of the columns or a group of columns.

6. Memory device (100) according to one of previous claims, wherein the memory circuit (140) includes at least one memory cell (146) of each column and is such that each of said memory cells (146) is able to store a desired polarization state of the second wells (133) of the memory cells (102) of the column to which said memory cell (146) belongs or several of said memory cells (146) are able to store a polarization state of the second wells (133) of the memory cells (102) of a group of columns to which the memory cells (146) belong.

7. Memory device (100) according to one of previous claims, wherein the polarization means of the second wells (133) of the memory cells (102) further includes:
- a test circuit (136) coupled to the matrix (134) of memory cells (102) and able to detect whether one or more memory cells (102) have a read speed creating read errors;
- a control circuit (138) coupled to the test circuit (136) and to the memory circuit (140) and able to define the polarization states intended to be stored in the memory circuit (140) as a function of results provided by the test circuit (136).

8. Memory device (100) according to one of previous claims, wherein the first type of conductivity corresponds to the P type and the second type of conductivity corresponds to the N type.

9. Memory device (100) according to one of previous claims, further including polarization means for the first wells (125) of the memory cells (102) able to apply a zero polarization on the first wells (125).

10. Memory device (100) according to one of previous claims, wherein each memory cell (102) includes at least four first FDSOI transistors (104, 106, 108, 110) forming two inverters mounted head-to-tail corresponding to the memory point and two second FDSOI transistors (116, 118) forming at least the write port, and in which:
- each memory cell (102) further includes two third FDSOI transistors (126, 128) forming the read port, the first (104, 106, 108, 110) and second (116, 118) FDSOI transistors including the first well (125), and the third FDSOI transistors (126, 128) including the second well (133), or
- the second FDSOI transistors (116, 118) also form the read port, the N-type transistors from among the first (104, 106, 108, 110) and second (116, 118) transistors including the first well (125), and the P-type transistors from among the first (104, 106, 108, 110) and second transistors (116, 118) including the second well (133), or
- each memory cell (102) further includes two third FDSOI transistors (126, 128) forming the read port, the N-type transistors from among the first (104, 106, 108, 110) and second (116, 118) transistors including the first well (125), and the third transistors (126, 128) and the P-type transistors from among the first (104, 106, 108, 110) and second (116, 118) transistors including the second well (133).

11. Polarization method for a memory device (100) according to one of the preceding claims, including the following steps:
- storing a desired polarization state of the second wells (133) of the memory cells (102) for each column or group of columns,
- selecting a value of at least one polarization potential of the second wells (133) as a function of the desired polarization state stored in the memory circuit (140) and associated with said column or said group of columns, and
- applying said polarization potential on the second wells (133) of said column or said group of columns.

12. Method according to claim 11, wherein a value of a supply voltage of the memory cells (102) of the memory device (100) and the value of said at least one polarization potential are chosen as a function of a desired read speed and electricity consumption of the memory device (100).

13. Method according to one of previous claims 11 or 12, further including a step for testing the matrix (134) of memory cells (102) detecting whether one or more memory cells (102) have a read speed creating read errors, and a step for determining polarization states intended to be stored as a function of results of the test step.

14. Method according to one of claims 11 to 13, wherein the value of the polarization potential applied on at least part of the second wells (133) is strictly positive.
